# EUROPEAN PATENT APPLICATION

(11) **EP 4 672 242 A1**
(43) Date of publication of application: **31.12.2025**
(21) Application number: 25176805.7
(22) Date of filing: 15.05.2025
(51) Int. Cl.: G11C 5/02, G11C 8/14

(54) **MEMORY DEVICE AND OPERATING METHOD THEREOF**

(30) Priority: 25.06.2024 KR 20240083033
(71) Applicant: Samsung Electronics Co., Ltd., Suwon-si, Gyeonggi-do 16677 (KR)
(72) Inventor: LEE, Sunggyeong, 16677 Suwon-si (KR); PARK, Youngseok, 16677 Suwon-si (KR); PARK, Chulkwon, 16677 Suwon-si (KR); SEO, Younghun, 16677 Suwon-si (KR); YOO, Changsik, 16677 Suwon-si (KR); YOON, Hyunchul, 16677 Suwon-si (KR); LEE, Hoseok, 16677 Suwon-si (KR)
(74) Representative: Marks & Clerk LLP

(57) **Abstract**

A memory device includes a plurality of word lines stacked in a vertical direction on a semiconductor substrate and including word line pads extending in a first direction, and a row decoder configured to provide a driving voltage to the plurality of word lines, wherein first word line pads provided at first end portions of a plurality of first word lines sequentially stacked among the plurality of word lines are connected to the row decoder, and second word line pads provided at second end portions of a plurality of second word lines sequentially stacked among the plurality of word lines are connected to the row decoder.

## Description

### BACKGROUND

The disclosure relates to a memory device, and more particularly, to a memory device including word lines driven in one direction or both directions and an operating method thereof.

Recently, as the degree of integration of electronic products has increased, a three-dimensional (3D) stack structure of semiconductor devices embedded in electronic products has emerged. In the 3D stack structure, word lines may be vertically stacked, and word lines may be coupled to a row decoder through a word line pad. The row decoder may provide a word line driving voltage to the word line through the word line pad.

### SUMMARY

One or more embodiments of the disclosure provide a memory device with a reduced signal interference between adjacent word lines.

An aspect of the invention is described at Claim 1. Another aspect of the invention is described at Claim 11.

According to an aspect of an example embodiment of the disclosure, there is provided a memory device including: a plurality of word lines stacked in a vertical direction on a semiconductor substrate and including word line pads, the plurality of word lines extending in a first direction; and a row decoder configured to provide a driving voltage to the plurality of word lines, wherein first word line pads provided at first end portions of a plurality of first word lines sequentially stacked, among the plurality of word lines, are connected to the row decoder, and wherein second word line pads provided at second end portions of a plurality of second word lines sequentially stacked, among the plurality of word lines, are connected to the row decoder.

According to an aspect of an example embodiment of the disclosure, there is provided an operating method of a memory device including a plurality of memory cells connected to a plurality of word lines, the operating method including: applying a first driving voltage to a first end portion of a first word line selected from among a plurality of first word lines adjacent in a vertical direction; applying a second driving voltage to first end portions of remaining first word lines, excluding the selected first word line, among the plurality of first word lines; and applying the second driving voltage to second end portions of a plurality of second word lines adjacent in the vertical direction.

According to an aspect of an example embodiment of the disclosure, there is provided a memory device including: a memory cell array including a plurality of memory cells; a plurality of word lines connected to the plurality of memory cells, each word line of the plurality of word lines including a first end portion and a second end portion; and a row decoder configured to provide a first driving voltage to the first end portion of each word line of two or more adjacent word lines included in a first word line group among the plurality of word lines, and configured to provide a second driving voltage to the second end portion of each word line of two or more adjacent word lines included in a second word line group among the plurality of word lines.

At least some of the above and other features of the invention are set out in the claims.

### BRIEF DESCRIPTION OF DRAWINGS

Example embodiments will be more clearly understood from the following detailed description taken in conjunction with the accompanying drawings in which:
FIG. 1 is a block diagram illustrating a memory device according to one or more embodiments;
FIG. 2 is a diagram illustrating a memory device according to one or more embodiments;
FIG. 3 is a diagram illustrating a memory device according to one or more embodiments;
FIGS. 4A and 4B are diagrams illustrating coupling capacitance between word lines;
FIG. 5 is a diagram illustrating a memory device according to one or more embodiments;
FIG. 6 is a diagram illustrating a memory device according to one or more embodiments;
FIG. 7 is a perspective view illustrating a memory device according to one or more embodiments;
FIG. 8 is a circuit diagram illustrating a memory cell region shown in FIG. 7 according to one or more embodiments;
FIG. 9 is a schematic perspective view illustrating a memory cell region of a memory device according to one or more embodiments;
FIG. 10 is a cross-sectional view of a memory device including the memory cell region taken along line A1-A1' of FIG. 9;
FIG. 11 is a cross-sectional view of a memory device including the memory cell region taken along line B1-B1' of FIG. 9;
FIG. 12 is a cross-sectional view of a memory device including the memory cell region taken along line B1-B1' of FIG. 9;
FIG. 13 is a layout view schematically illustrating a memory device according to one or more embodiments;
FIG. 14 is a cross-sectional view of a memory device including the memory cell region taken along line B1-B1' of FIG. 9;
FIG. 15 is a cross-sectional view of a memory device including the memory cell region taken along line B1-B1' of FIG. 9;
FIG. 16 is a flowchart illustrating an operating method of a memory device according to one or more embodiments;
FIG. 17 is a diagram illustrating voltages applied to word lines according to one or more embodiments; and
FIG. 18 is a diagram illustrating voltages applied to word lines according to one or more embodiments.

### DETAILED DESCRIPTION

Hereinafter, one or more example embodiments of the disclosure will be described in detail with reference to the accompanying drawings.

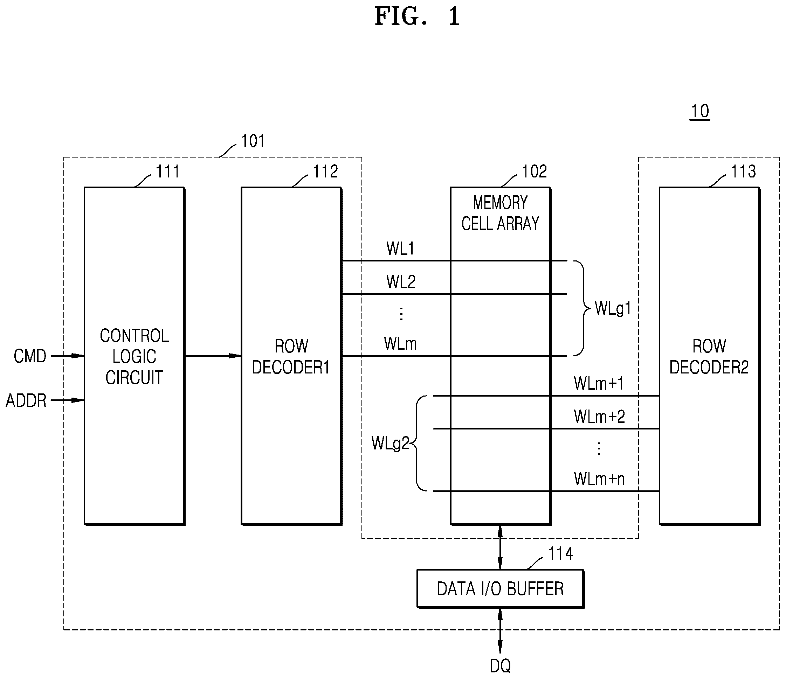

FIG. 1 is a block diagram illustrating a memory device 10 according to one or more embodiments.

Referring to FIG. 1, the memory device 10 may include a memory cell array 102 and a peripheral circuit 101.

The peripheral circuit 101 may include a control logic circuit 111, a first row decoder 112, a second row decoder 113, and a data input/output buffer 114. Although not shown in FIG. 1, the peripheral circuit 101 may further include a voltage generator, a predecoder, a temperature sensor, a command decoder, an address decoder, etc.

The memory cell array 102 may be connected to the first row decoder 112 through word lines WL1 to WLm and may be connected to the second row decoder 113 through word lines WLm+1 to WLm+n. The word lines WL1 to WLm may be referred to as a first word line group WLg1, and the word lines WLm+1 to WLm+n may be referred to as a second word line group WLg2. The memory cell array 102 may include a plurality of memory cells. For example, a memory cell may be a nonvolatile memory cell or a volatile memory cell. For example, the memory cell may be a dynamic random access memory (DRAM) cell, a NAND cell, a resistive RAM (ReRAM) cell, a phase change RAM (PRAM) cell, a static random access memory (SRAM) cell, or a magnetic RAM (MRAM) cell.

In one or more embodiments, the memory cell array 102 may include a three-dimensional (3D) memory cell array. For example, the 3D memory cell array may include 3D DRAM cells. The 3D DRAM cells may include memory cells respectively connected to word lines vertically stacked on a substrate. For example, the 3D memory cell array may include a plurality of NAND cell strings, and each of the plurality of NAND cell strings may include memory cells respectively connected to word lines vertically stacked on the substrate.

Data DQ input through the data input/output buffer 114 may be written to the memory cell array 102 based on an address ADDR, and the data DQ read from the memory cell array 102 based on the address ADDR may be output to an outside through the data input/output buffer 114.

The first row decoder 112 and the second row decoder 113 may each decode a row address based on the address ADDR. The first row decoder 112 and the second row decoder 113 may each select a word line by decoding the row address. In addition, the first row decoder 112 and the second row decoder 113 may each provide a driving voltage to a word line corresponding to the row address. In some embodiments, each of the first row decoder 112 and the second row decoder 113 may include a sub word line driver. The sub word line driver may apply a driving voltage to the selected word line.

According to one or more embodiments, the first row decoder 112 may provide the driving voltage to first end portions (or terminals) of both end portions of the word lines WL1 to WLm, and the second row decoder 113 may provide the driving voltage to second end portions (or terminals) of the both end portions of the word lines WLm+1 to WLm+n. Thus, the first row decoder 112 may drive the word lines WL1 to WLm in a first direction (e.g., the right direction), and the second row decoder 113 may drive the word lines WLm+1 to WLm+n in a second direction (e.g., the left direction). The first row decoder 112 may be physically connected to the first end portions of the word lines WL1 to WLm, and the second row decoder 113 may be physically connected to the second end portions of the word lines WLm+1 to WLm+n. The term "connected" or "physically connected" as used herein may refer, without limitation, to one or more components that are connected to another component(s) either directly and/or via electric connection, including connecting via one or more intermediate component(s) therebetween.

The word lines WL1 to WLm may be two or more word lines adjacent to each other, and the word lines WLm+1 to WLm+n may be two or more word lines adjacent to each other. When the memory cell array 102 is a 3D memory cell array, the word lines WL1 to WLm may be a plurality of word lines stacked adjacent to each other, and the word lines WLm+1 to WLm+n may be a plurality of word lines stacked adjacent to each other.

When the memory cell array 102 is the 3D memory cell array, the word lines WL1 to WLm+n may respectively receive driving voltages through word line contacts connected to word line pads having a step structure. When the word lines WL1 to WLm+n alternately receive driving voltages in opposite directions, adjacent word lines may be driven in opposite directions, which may increase signal interference between word lines. When the word lines WL1 to WLm+n alternately receive driving voltages in opposite directions, word line pads connected to word line contacts corresponding to a half of a number of stacked word lines may be provided at first end portions of the stacked word lines. In addition, word line pads connected to word line contacts corresponding to a half of the number of the stacked word lines may be provided at second end portions of the stacked word lines. Therefore, a lowermost word line pad provided at a first end portion or a second end portion of a lowermost word line may have a length proportional to a number corresponding to the half of the number of the stacked word lines.

When all of the word lines WL1 to WLm+n receive driving voltages in the same direction (e.g., the right direction), because the first end portions of the stacked word lines are connected to word line contacts, the lowermost word line pad provided at the first end portion of the lowermost word line may have a length proportional to the number of the stacked word lines. Therefore, coupling capacitance values between word lines may increase.

According to one or more embodiments, word lines included in one word line group may be driven in the same direction and word lines included in different word line groups may be driven in different directions, thereby reducing signal interference between word lines and reducing coupling capacitance values between the word lines.

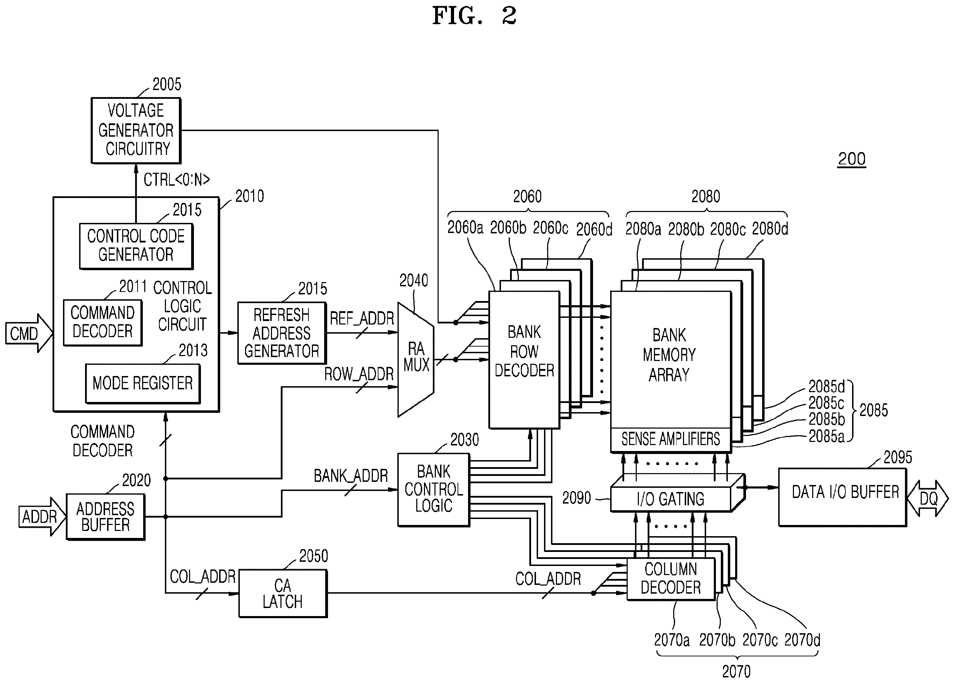

FIG. 2 is a diagram illustrating a memory device 200 according to one or more embodiments. The memory device 200 may be implemented in a DRAM.

Referring to FIG. 2, the memory device 200 may include a voltage generator circuitry 2005, a control logic circuit 2010, a refresh address generator 2015, an address buffer 2020, a bank control logic 2030, a row address multiplexer 2040, a column address latch 2050, a row decoder 2060, a column decoder 2070, a memory cell array 2080, a sense amplifier 2085, an input/output gating circuit 2090, and a data input/output buffer 2095.

The memory cell array 2080 may include first to fourth bank arrays 2080a, 2080b, 2080c, and 2080d. Each of the first to fourth bank arrays 2080a, 2080b, 2080c, and 2080d may include a plurality of word lines, a plurality of bit lines, and a plurality of memory cells provided at points in which the plurality of word lines and the plurality of bit lines intersect. Each of the first to fourth bank arrays 2080a, 2080b, 2080c, and 2080d may correspond to the memory cell array 102 of FIG. 1.

The row decoder 2060 may include first to fourth bank row decoders 2060a, 2060b, 2060c, and 2080d connected to the first to fourth bank arrays 2080a, 2080b, 2080c, and 2080d, respectively. The column decoder 2070 may include first to fourth bank column decoders 2070a, 2070b, 2070c, and 2070d connected to the first to fourth bank arrays 2080a, 2080b, 2080c, and 2080d, respectively. The sense amplifier unit 2085 may include first to fourth bank sense amplifiers 2085a, 2085b, 2085c, and 2085d connected to the first to fourth bank arrays 2080a, 2080b, 2080c, and 2080d, respectively. Each of the first to fourth bank row decoders 2060a, 2060b, 2060c, and 2060d may include the first row decoder 112 and the second row decoder 113 of FIG. 1. That is, for convenience of illustration, FIG. 2 illustrates that each of the first to fourth bank row decoders 2060a, 2060b, 2060c, and 2060d drives a corresponding bank array in one direction, but each of the first to fourth bank row decoders 2060a, 2060b, 2060c, and 2060d may drive word line groups of the corresponding bank array in different directions.

The first to fourth bank arrays 2080a, 2080b, 2080c, and 2080d, the first to fourth bank row decoders 2060a, 2060b, 2060c, and 2060d, the first to fourth bank column decoders 2070a, 2070b, 2070c, and 2070d, and the first to fourth bank sense amplifiers 2085a, 2085b, 2085c, and 2085d may constitute first to fourth memory banks, respectively. An example of the memory device 200 including four memory banks is shown in the embodiment, but according to one or more embodiments, the memory device 200 may include an arbitrary number of memory banks.

The control logic circuit 2010 may control overall operations of the memory device 200. The control logic circuit 2010 may generate control signals for the memory device 200 to perform a write operation and/or a read operation. The control logic circuit 2010 may include a command decoder 2011 configured to decode a received command CMD and a mode register 2013 configured to set an operation mode of the memory device 200. The command decoder 2011 may decode a write enable signal /WE, a row address strobe signal /RAS, a column address strobe signal /CAS, a chip selection signal /CS, etc. to generate control signals corresponding to the command CMD. The mode register 2013 may provide a plurality of operation options of the memory device 200 and have various functions, characteristics, and/or modes of the memory device 200 programmed thereon.

The control logic circuit 2010 may control the refresh address generator 2015 to perform an auto-refresh operation in response to a refresh command, and/or control the refresh address generator 2015 to perform a self-refresh operation in response to a self-refresh entry command. The refresh address generator 2015 may generate a refresh row address REF_ADDR corresponding to a memory cell row in which a refresh operation is to be performed. The refresh address generator 2015 may generate the refresh row address REF_ADDR at a refresh cycle defined in a standard of a volatile memory device.

The address buffer 2020 may receive an address ADDR including a bank address BANK_ADDR, a row address ROW_ADDR, and a column address COL_ADDR from a memory controller. In addition, the address buffer 2020 may provide the received bank address BANK_ADDR to the bank control logic 2030, the received row address ROW_ADDR to the row address multiplexer 2040, and the received column address COL_ADDR to the column address latch 2050.

The bank control logic 2030 may generate a bank control signal in response to the bank address BANK_ADDR. In response to the bank control signal, a bank row decoder corresponding to the bank address BANK_ADDR among the first to fourth bank row decoders 2060a, 2060b, 2060c, and 2060d may be activated, and a bank column decoder corresponding to the bank address BANK_ADDR among the first to fourth bank column decoders 2070a, 2070b, 2070c, and 2070d may be activated.

The row address multiplexer 2040 may receive the row address ROW_ADDR from the address buffer 2020 and the refresh row address REF_ADDR from the refresh address generator 2015. The row address multiplexer 2040 may selectively output the row address ROW_ADDR or the refresh row address REF_ADDR. The row address ROW_ADDR or the refresh row address REF_ADDR output from the row address multiplexer 2040 may be applied to each of the first to fourth bank row decoders 2060a, 2060b, 2060c, and 2060d.

The bank row decoder activated by the bank control logic 2030 among the first to fourth bank row decoders 2060a, 2060b, 2060c, and 2060d may decode the row address ROW_ADDR or the refresh row address REF_ADDR output from the row address multiplexer 2040 to activate a word line corresponding to the row address ROW_ADDR or the refresh row address REF_ADDR. For example, the activated bank row decoder may apply a driving voltage to the word line corresponding to the row address ROW_ADDR or the refresh row address REF_ADDR. The first to fourth bank row decoders 2060a, 2060b, 2060c, and 2060d may include a plurality of sub word line drivers connected to the word lines, respectively. A sub word line driver may apply a driving voltage to the word line corresponding to the row address ROW_ADDR or the refresh row address REF_ADDR.

The column address latch 2050 may receive the column address COL_ADDR from the address buffer 2020 and temporarily store therein the received column address COL_ADDR. The column address latch 2050 may gradually increase the received column address COL_ADDR in a burst mode. The column address latch 2050 may apply the temporarily stored or gradually increased column address COL_ADDR to each of the first to fourth bank column decoders 2070a, 2070b, 2070c, and 2070d.

The bank column decoder activated by the bank control logic 2030 among the first to fourth bank column decoders 2070a, 2070b, 2070c, and 2070d may activate a sense amplifier corresponding to the bank address BANK_ADDR and the column address COL_ADDR through the input/output gating circuit 2090.

The input/output gating circuit 2090 may include an input data mask logic, read data latches configured to store read data output from the first to fourth bank arrays 2080a, 2080b, 2080c, and 2080d, and a write driver configured to write data to the first to fourth bank arrays 2080a, 2080b, 2080c, and 2080d, together with circuits gating the input/output data DQ.

The read data output from one bank array of the first to fourth bank arrays 2080a, 2080b, 2080c, and 2080d may be sensed by sense amplifiers corresponding to the one bank array and stored in the read data latches. Write data to be written to a memory cell array of one bank array of the first to fourth bank arrays 2080a, 2080b, 2080c, and 2080d may be provided from the memory controller to the data input/output buffer 2095. The write data provided to the data input/output buffer 2095 may be written to the one bank array through the write driver.

The data input/output buffer 2095 may receive the input/output data DQ and provide the input/output data DQ to the input/output gating circuit 2090.

The first to fourth bank arrays 2080a, 2080b, 2080c, and 2080d may be included in the memory cell array 102 of FIG. 1, and remaining components and/or circuits may be included in the peripheral circuit 101 of FIG. 1.

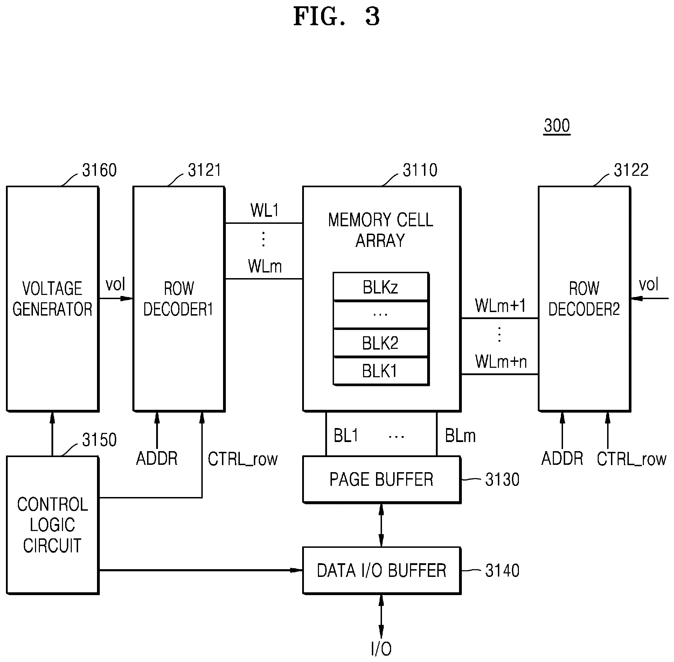

FIG. 3 is a diagram illustrating a memory device 300 according to one or more embodiments.

Referring to FIG. 3, the memory device 300 may include a memory cell array 3110, a first row decoder 3121, a second row decoder 3122, a page buffer 3130, a data input/output buffer 3140, a control logic circuit 3150, and a voltage generator 3160. According to one or more embodiments, the memory device 300 may be a nonvolatile memory including a flash memory device, an MRAM, a ReRAM, and a FRAM.

The memory cell array 3110 may be connected to the first row decoder 3121 and the second row decoder 3122 through word lines WL1 to WLm+n. The memory cell array 3110 may be connected to the page buffer 3130 through bit lines BL1 to BLm. The page buffer 3130 may operate as a write driver or a sense amplifier according to an operation mode. For example, during a program operation, the page buffer 3130 may transmit a voltage corresponding to data to be programmed to the bit lines BL1 to BLm. In addition, during a read operation, the page buffer 3130 may detect data stored in a selected memory cell through the bit lines BL0 to BLm and transmit the data to the input/output buffer 3140. The input/output buffer 3140 may transmit the input data to the page buffer 3130 or output data provided from the page buffer 3130 to the outside.

The control logic circuit 3150 may control various components included in the memory device 300. For example, the control logic circuit 3150 may generate internal control signals according to commands from the outside such as a program and/or read operation, etc. For example, the control logic circuit 3150 may control the voltage generator 3160 to generate voltages vol of various levels used for the program and/or read operation, etc. In addition, the control logic circuit 3150 may control input and output timings of data by controlling the data input/output buffer 3140. The control logic circuit 3150 may generate a control signal CTRL_row to control the first row decoder 3121 and the second row decoder 3122. The first row decoder 3121 and the second row decoder 3122 may perform a selection operation of the memory cell array 3110 on a cell block and a signal line based on the control signal CTRL_row.

The voltage generator 3160 may generate various types of word line voltages to be supplied to the word lines WL1 to WLm+n respectively and a bulk voltage to be supplied to a bulk (e.g., a well region) in which memory cells are positioned based on a control of the control logic circuit 3150. For example, in relation to a program operation, the voltage generator 3160 may generate a program voltage provided to a selected word line and a pass voltage provided to an unselected word line. In addition, in relation to a read operation, the voltage generator 3160 may generate a selected word line voltage and an unselected word line voltage having different levels. In addition, the voltage generator 3160 may provide a high-voltage erase voltage to a bulk in which the selected memory cell array is positioned during an erase operation.

The memory cell array 3110 may include a plurality of cell blocks. As described above with reference to FIG. 1, the first row decoder 3121 and the second row decoder 3122 may drive corresponding word line groups in opposite directions. For example, the first row decoder 3121 may be connected to first end portions of word lines WL1 to WLm included in a first word line group, and drive the first word line group in a first direction. The second row decoder 3122 may be connected to second end portions of word lines WLm+1 to WLm+n included in a second word line group, and may drive the second word line group in a second direction. However, a number of word line groups driven by the first row decoder 3121 and the second row decoder 3122 and a number of word lines included in each word line group is not limited thereto.

Hereinafter, the first row decoder 3121 will be described in more detail. The description of the first row decoder 3121 may be applied to the second row decoder 3122.

The first row decoder 3121 may perform an operation related to selection of a corresponding cell block. For example, when a cell block is selected, word line voltages may be provided to the word lines WL1 to WLm of the corresponding cell block, and when a cell block is not selected, word line voltages may be blocked from being provided to the word lines WL1 to WLm of the corresponding cell block. For the above operation, the first row decoder 3121 may include a block selector, and transmission of word line voltages may be controlled through a switching operation of a pass transistor provided in the block selector.

The memory device 300 may be a flash memory device, and the memory cell array 3110 may include a plurality of NAND cell strings. Each of the plurality of NAND cell strings may form a channel in a vertical direction or a horizontal direction. Memory cells included in each of the plurality of NAND cell strings may be programmed or erased by high voltages provided from the first row decoder 3121 and the second row decoder 3122.

In addition, the memory cell array 3110 may be connected to the first row decoder 3121 and the second row decoder 3122 through other lines in addition to the word lines WL1 to WLm+n. For example, the memory cell array 3110 may be connected to the first row decoder 3121 or the second row decoder 3122 through one or more string selection lines SSL and ground selection lines GSL. The string selection lines SSL, the word lines WL1 to WLm+n, and the ground selection lines GSL may be referred to as signal lines. In addition, a voltage provided to a signal line may be referred to as a driving voltage.

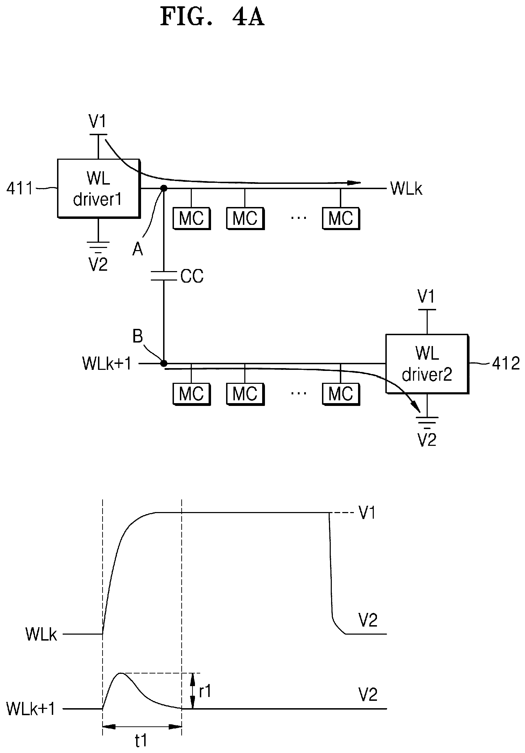

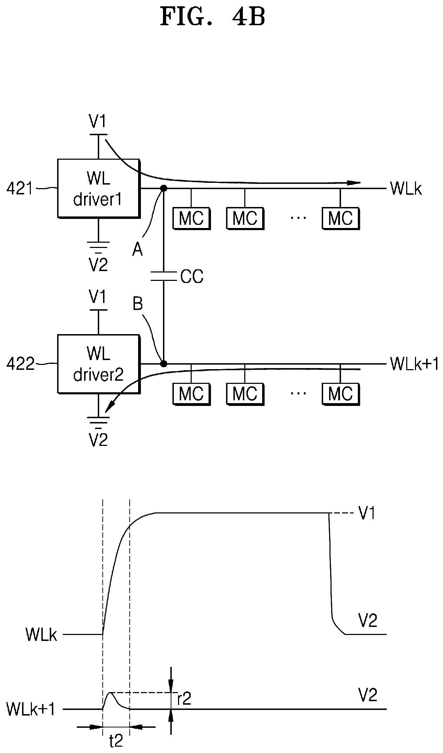

FIGS. 4A and 4B are diagrams illustrating coupling capacitance CC between a word line WLk and a word line WLk+1.

Referring to FIG. 4A, the word line WLk and the word line WLk+1 may be adjacent to each other. Each of the word line WLk and the word line WLk+1 may be connected to a plurality of memory cells MC. The coupling capacitance CC may be formed between the word line WLk and the word line WLk+1.

A first word line driver 411 may drive the word line WLk using a first voltage V1 in a first direction (e.g., the right direction), and a second word line driver 412 may drive the word line WLk+1 using a second voltage V2 in a second direction (e.g., the left direction). That is, the first word line driver 411 and the second word line driver 412 may respectively drive the word line WLk and the word line WLk+1 in opposite directions. The first voltage V1 may be greater than the second voltage V2.

A voltage of the word line WLk may increase from the second voltage V2 to the first voltage V1. While the voltage of the word line WLk increases, ripple r1 may occur in the word line WLk+1 due to the coupling capacitance CC. The second word line driver 412 may provide the second voltage V2 to the word line WLk+1, and thus, the ripple r1 may be maintained during a first time t1and disappeared after the first time t1. Position A may be a position most strongly driven by the first word line driver 411 in the word line WLk. Position B may be a position most strongly affected by the first voltage V1 applied to the word line WLk in the word line WLk+1.

Referring to FIG. 4B, a first word line driver 421 may drive the word line WLk using the first voltage V1 in the first direction (e.g., the right direction), and a second word line driver 422 may drive the word line WLk+1 using the second voltage V2 in the first direction (e.g., the right direction). That is, the first word line driver 411 and the second word line driver 412 may drive the word line WLk and the word line WLk+1 in the same direction.

As in FIG. 4A, while the voltage of the word line WLk increases, ripple r2 may occur in the word line WLk+1 due to the coupling capacitance CC. However, compared with the second word line driver 412 of FIG. 4A, because the second word line driver 422 is located relatively close to the position B that is most strongly affected by the first voltage V1 applied to the word line WLk+1 in the word line WLk, the second word line driver 422 may relatively quickly stabilize the voltage of the word line WLk+1 to the second voltage V2. That is, a size of the ripple r2 may be smaller than a size of the ripple r1, and a second time t2 during which the ripple r2 is maintained may be shorter than the first time t1. Therefore, signal interference may be reduced when adjacent word lines are driven in the same direction compared to when adjacent word lines are driven in opposite directions.

According to one or more embodiments, signal interference between adjacent word lines may be reduced by driving a plurality of word lines included in the same word line group in the same direction.

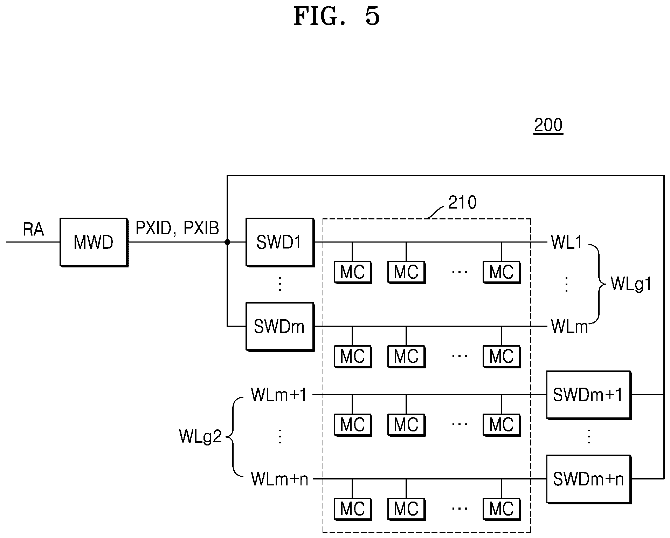

FIG. 5 is a diagram illustrating a memory device 200 according to one or more embodiments.

Referring to FIG. 5, the memory device 200 may include a bank array 210, a main word line driver MWD, and a plurality of sub word line drivers SWD1 to SWDm+n. The bank array 210 may include a plurality of memory cells MC connected to word lines WL1 to WLm+n. Word lines WL1 to WLm may be included in a first word line group WLg1, and word lines WLm+1 to WLm+n may be included in a second word line group WLg2. The bank array 210 may correspond to one of the first to fourth bank arrays 2080a to 2080d of FIG. 2. The main word line driver MWD and the plurality of sub word line drivers SWD1 to SWDm+n may be included in one of the first to fourth bank row decoders 2060a to 2060d included in the row decoder 2060 of FIG. 2.

The main word line driver MWD may receive a row address RA and generate a delayed sub word line signal PXID and an inverted sub word line signal PXIB.

The plurality of sub word line drivers SWD1 to SWDm+n may drive the word lines WL1 to WLm+n based on the delayed sub word line signal PXID and the inverted sub word line signal PXIB. Specifically, a first voltage may be provided to a selected word line, and a second voltage may be provided to an unselected word line. The first voltage may be greater than the second voltage. For example, the first voltage may be VPP, and the second voltage may be VBB.

Sub word line drivers SWD1 to SWDm may be connected to first end portions of the word lines WL1 to WLm. The sub word line drivers SWD1 to SWDm may drive the word lines WL1 to WLm in a first direction (e.g., in the right direction).

Sub word line drivers SWDm+1 to SWDm+n may be connected to second end portions of the word lines WLm+1 to WLm+n. The sub word line drivers SWDm+1 to SWDm+n may drive the word lines WLm+1 to WLm+n in a second direction (e.g., in the left direction).

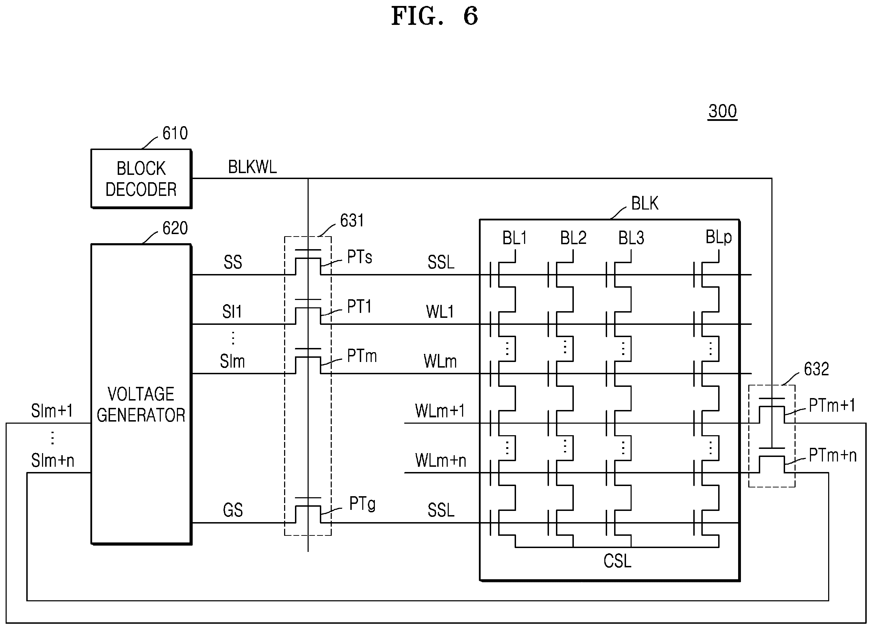

FIG. 6 is a diagram illustrating a memory device 300 according to one or more embodiments.

Referring to FIG. 6, the memory device 300 may include a memory block BLK, a block decoder 610, a voltage generator 620, a first pass transistor group 631, and a second pass transistor group 632. The block decoder 610 may be included in at least one of the first row decoder 3121 and the second row decoder 3122 of FIG. 3. For example, the first pass transistor group 631 may be included in the first row decoder 3121 of FIG. 3, and the second pass transistor group 632 may be included in the second row decoder 3122 of FIG. 3.

The block decoder 610 may provide a block selection signal to each of the first pass transistor group 631 and the second pass transistor group 632 through a block selection line BLKWL. The block selection signal may be provided to each of gate terminals of a plurality of pass transistors PTs, PT1 to PTm+n, and PTg included in the first pass transistor group 631 and the second pass transistor group 632. For example, when the block selection signal is activated, the plurality of pass transistors PTs, PT1 to PTm+n, and PTg may be turned on, and accordingly, the memory block BLK may be selected. The one block selection line BLKWL may be commonly connected to the plurality of pass transistors PTs, PT1 to PTm+n, and PTg, but the embodiment is not limited thereto. In some embodiments, at least two or more of the plurality of pass transistors PTs, PT1 to PTm+n, and PTg may be connected to two or more block selection lines BLKWL, respectively.

The voltage generator 620 may be connected to the first pass transistor group 631 and the second pass transistor group 632 through a string selection line driving signal line SS, word line driving signal lines SI1 to SIm+n, and a ground selection line driving signal line GS.

The first pass transistor group 631 may be connected to the memory block BLK through a string selection line SSL, word lines WL1 to WLm, and a ground selection line GSL. The second pass transistor group 632 may be connected to the memory block BLK through word lines WLm+1 to WLm+n.

When the block selection signal is activated, the plurality of pass transistors PTs, PT1 to PTm+n, and PTg may provide driving signals provided through the string selection line driving signal line SS, the word line driving signal lines SI1 to SIm+n, and the ground selection line driving signal line GS to the string selection line SSL, the plurality of word lines WL1 to WLm+n, and the ground selection line GSL, respectively.

The pass transistors PT1 to PTm may be connected to first end portions of the word lines WL1 to WLm. The pass transistors PT1 to PTm may drive the word lines WL1 to WLm in the first direction (e.g., the right direction).

The pass transistors PTm+1 to PTm+n may be connected to second end portions of the word lines WLm+1 to WLm+n. The pass transistors PTm+1 to PTm+n may drive the word lines WLm+1 to WLm+n in the second direction (for example, in the left direction).

The pass transistors PTs and PTg are shown to be included in the first pass transistor group 631, but the embodiment is not limited thereto. The pass transistors PTs and PTg may be included in the second pass transistor group 632.

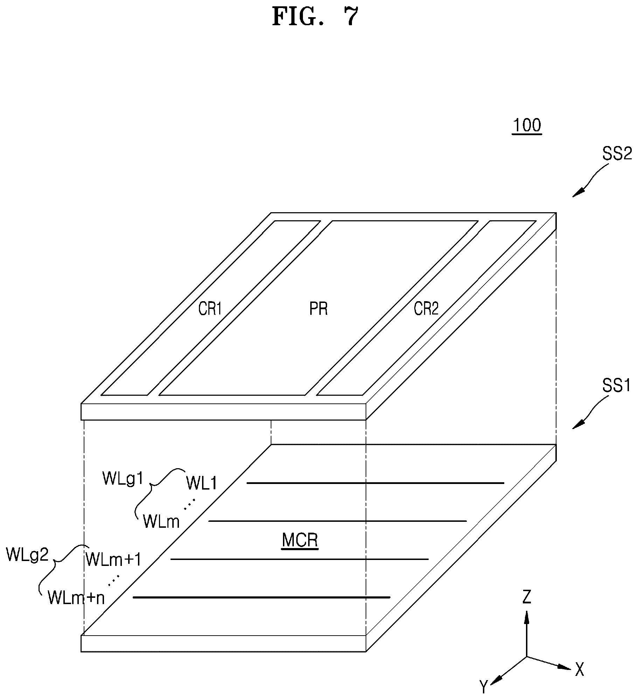

FIG. 7 is a perspective view illustrating a memory device 100 according to one or more embodiments.

Referring to FIG. 7, the memory device 100 may have a structure in which a first stack structure SS1 and a second stack structure SS2 are stacked in a vertical direction (e.g., Z-axis direction). For example, the first stack structure SS1 and the second stack structure SS2 may be disposed at different vertical levels. FIG. 7 illustrates that the first stack structure SS1 and the second stack structure SS2 are separated for convenience of understanding, but the memory device 100 may have a structure in which a bottom surface of the second stack structure SS2 is disposed on (or attached to) an upper surface of the first stack structure SS1.

The first stack structure SS1 may include a memory cell region MCR. The memory cell region MCR may be a region in which the memory cell arrays 102, 2080, and 3110 described with reference to FIGS. 1 to 3 are disposed. Furthermore, the memory cell region MCR may be a region in which the word lines WL1 to WLm+n are disposed. The word lines WL1 to WLm may be referred to as the first word line group WLg1, and the word lines WL1 to WLm may be adjacent to each other. The word lines WLm+1 to WLm+n may be referred to as the second word line group WLg2, and the word lines WLm+1 to WLm+n may be adjacent to each other. Furthermore, the memory cell region MCR may include bit lines.

The second stack structure SS2 may include a first core region (or first semiconductor region) CR1, a second core region (or second semiconductor region) CR2, and a peripheral circuit region PR. The first core region CR1 may be disposed at a position overlapping first end portions of the word lines WL1 to WLm+n in the vertical direction. The first core region CR1 may include a row decoder (e.g., 112 of FIG. 1) configured to provide driving voltages to the first end portions of the word lines WL1 to WLm. The second core region CR2 may be disposed at a position overlapping second end portions of the word lines WL1 to WLm+n in the vertical direction. The second core region CR2 may include a row decoder (e.g., 113 of FIG. 1) configured to provide driving voltages to second end portions of the word lines WLm+1 to WLm+n.

The peripheral circuit region PR may be disposed at a position overlapping the memory cell region MCR in the vertical direction. Components and/or circuits described above with reference to FIGS. 1 to 3, other than the memory cell arrays 102, 2080, and 3110 and the first row decoders 112 and 3121, the second row decoders 113 and 3122, and the row decoder 2060 may be disposed in the peripheral circuit region PR.

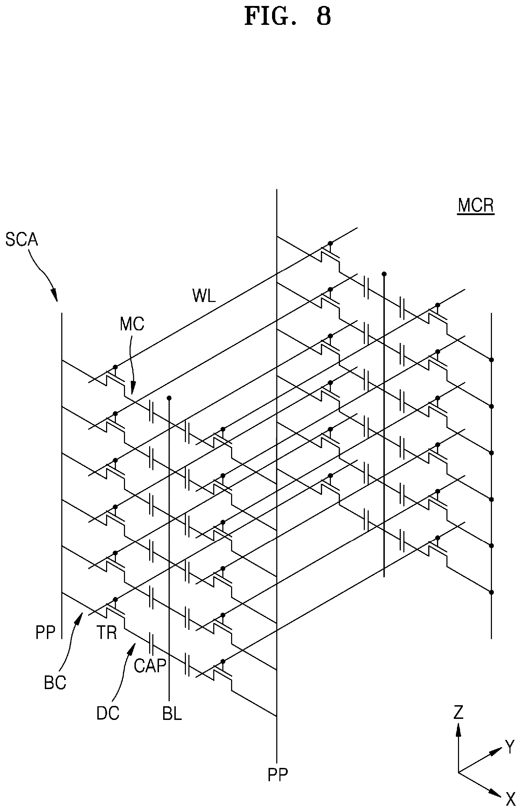

FIG. 8 is a circuit diagram illustrating the memory cell region MCR shown in FIG. 7 according to one or more embodiments.

Referring to FIG. 8, the memory cell region MCR may include a plurality of sub cell arrays SCA. The plurality of sub cell arrays SCA may be spaced apart from each other in a second horizontal direction Y. A sub cell array SCA may correspond to one of the first to fourth bank arrays 2080a to 2080d of FIG. 2. A combination of the two or more sub cell arrays SCA may correspond to one of the first to fourth bank arrays 2080a to 2080d of FIG. 2.

In some embodiments, the sub cell array SCA may include a plurality of bit lines BL, a plurality of word lines WL, and a plurality of memory cells MC. Each of the plurality of memory cells MC may include one cell transistor TR and one cell capacitor CAP connected thereto. Each of the plurality of memory cells MC may have a 1 transistor-1 capacitor (1T1C) structure.

In some embodiments, the plurality of word lines WL may extend along the second horizontal direction Y and may be spaced apart from each other in a first horizontal direction X and a vertical direction Z. The plurality of bit lines BL may extend in the vertical direction Z and may be spaced apart from each other in each of the first horizontal direction X and the second horizontal direction Y. One cell transistor TR may be disposed between one word line WL and one bit line BL.

In some embodiments, a gate of the cell transistor TR may be connected to the word line WL, and a source of the cell transistor TR may be connected to a plate electrode PP through a first contact BC. The cell transistor TR may be connected to the cell capacitor CAP through a second contact DC. A drain of the cell transistor TR may be connected to a first electrode of the cell capacitor CAP through the second contact DC, and a second electrode of the cell capacitor CAP may be connected to a bit line BL.

In FIG. 8, plate electrodes PP are spaced apart from each other in the second horizontal direction Y, but the embodiment is not limited thereto. Two or more plate electrodes PP spaced apart in the second horizontal direction Y may be combined into one plate electrode PP.

In some embodiments, the plurality of cell transistors TR may be disposed at positions overlapping each other in the vertical direction Z within one sub cell array SCA. The plurality of cell capacitors CAP may be disposed at positions overlapping each other in the vertical direction Z within one sub cell array SCA. One cell transistor TR and one cell capacitor CAP may be disposed side by side at the same vertical level, and the plurality of memory cells MC each including one cell transistor TR and one cell capacitor CAP may be stacked in the vertical direction Z. A storage capacity of the sub cell array SCA may vary depending on a number of the memory cells MC stacked in the vertical direction Z or a number of layers of the memory cells MC (e.g., a number of the cell capacitors CAP or a number of layers of the cell capacitors CAP that are stacked). FIG. 8 illustrates that two memory cells MC share one bit line BL in one layer, but the embodiment is not limited thereto. In addition, the sub cell array SCA is illustrated to include the memory cells MC stacked in six layers, but the embodiment is not limited thereto.

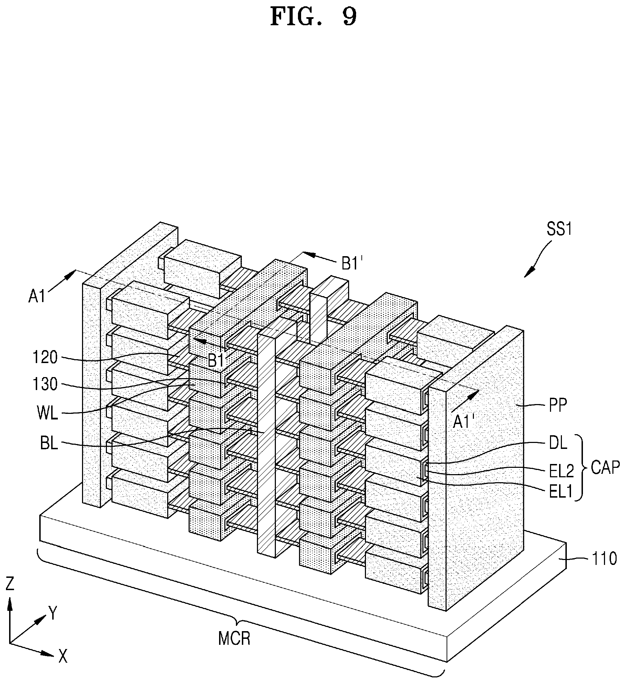

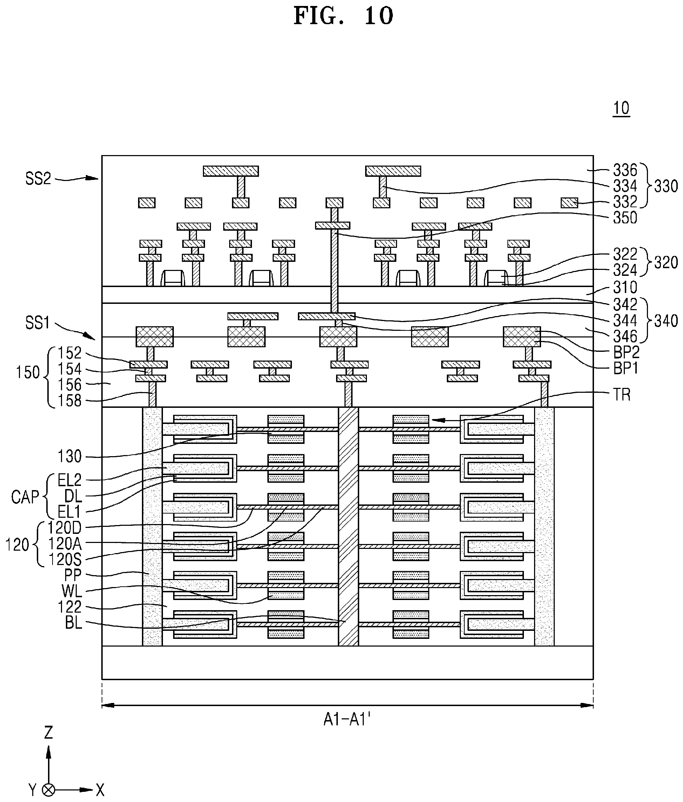

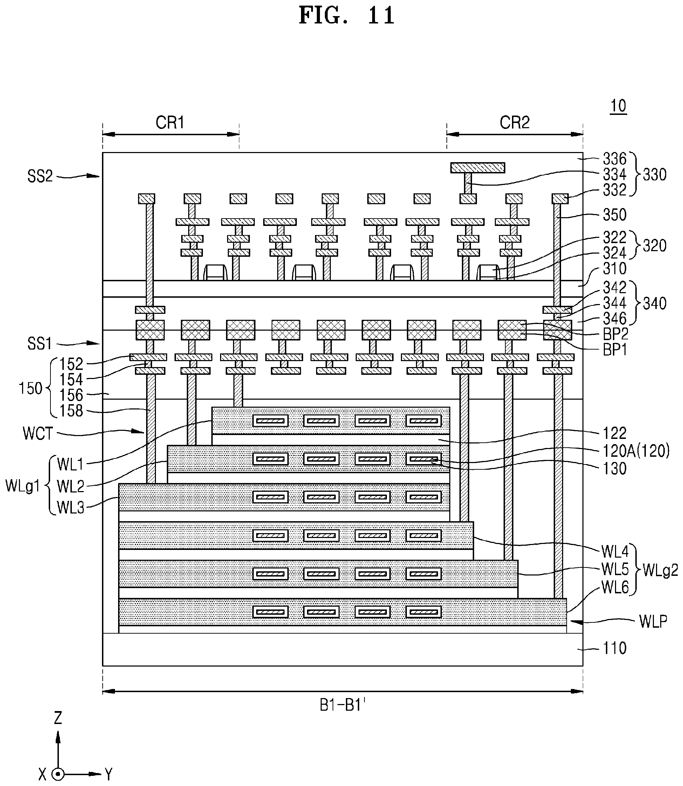

FIG. 9 is a schematic perspective view illustrating the memory cell region MCR of the memory device 10 according to one or more embodiments. FIG. 10 is a cross-sectional view of the memory device 10 including the memory cell region MCR taken along line A1-A1' of FIG. 9. FIG. 11 is a cross-sectional view of the memory device 10 including the memory cell region MCR taken along line B1-B1' of FIG. 9.

Referring to FIGS. 9 to 11, the memory device 10 may include the first stack structure SS1 and the second stack structure SS2, and the second stack structure SS2 may be bonded onto the first stack structure SS1 by a first bonding pad BP1 and a second bonding pad BP2.

In some embodiments, the first stack structure SS1 may include a first substrate 110, a plurality of semiconductor patterns 120 disposed on the first substrate 110, the plurality of bit lines BL, the plurality of word lines WL, and the cell capacitor CAP.

In some embodiments, the first substrate 110 may include Si, Ge, or SiGe. In some embodiments, the first substrate 110 may include a silicon-on-insulator (SOI) substrate or a germanium-on-insulator (GeOI) substrate.

In some embodiments, the plurality of semiconductor patterns 120 may extend in the first horizontal direction X and may be spaced apart from each other in the vertical direction Z on the first substrate 110.

In some embodiments, the plurality of semiconductor patterns 120 may include, for example, an undoped semiconductor material or a doped semiconductor material. In some embodiments, the plurality of semiconductor patterns 120 may include polysilicon. In some embodiments, the plurality of semiconductor patterns 120 may include an amorphous metal oxide, a polycrystalline metal oxide, or a combination of the amorphous metal oxide and the polycrystalline metal oxide, and for example, may include at least one of In-Ga-based oxide (IGO), In-Zn-based oxide (IZO), or In-Ga-Zn-based oxide (IGZO). In some embodiments, the plurality of semiconductor patterns 120 may each include a two-dimensional (2D) material semiconductor, and, for example, the 2D material semiconductor may include MoS₂, WSe₂, graphene, carbon nano tube, or a combination thereof.

In some embodiments, the plurality of semiconductor patterns 120 may have a line shape or a bar shape extending in the first horizontal direction X. In some embodiments, each semiconductor pattern 120 may include a channel region 120A, and a first impurity region 120S and a second impurity region 120D disposed in the first horizontal direction X with the channel region 120A disposed therebetween. The first impurity region 120S may be connected to the bit line BL, and the second impurity region 120D may be connected to the cell capacitor CAP. An ohmic metal layer including metal silicide etc. may be further formed between the first impurity region 120S and the bit line BL and between the second impurity region 120D and the cell capacitor CAP.

In some embodiments, the first impurity region 120S and the second impurity region 120D may each have a P-type conductivity type. For example, the first impurity region 120S and the second impurity region 120D may include P-type impurities such as boron (B), gallium (Ga), or aluminum (Al). For example, the first impurity region 120S and the second impurity region 120D may include polysilicon doped with the P-type impurities.

In some embodiments, a plurality of word lines WL1 to WL6 may include at least one of a doped semiconductor material (doped silicon, doped germanium, etc.), conductive metal nitride (titanium nitride, tantalum nitride, etc.), a metal (tungsten, titanium, tantalum, etc.), or a metal-semiconductor compound (tungsten silicide, cobalt silicide, titanium silicide, etc.).

In some embodiments, a gate insulating layer 130 may be disposed between the word line WL and the semiconductor pattern 120. The gate insulating layer 130 may include at least one of a high-k dielectric material having a higher dielectric constant than silicon oxide or a ferroelectric material. In some embodiments, the gate insulating layer 130 may include at least one material selected from hafnium oxide (HfO), hafnium silicate (HfSiO), hafnium oxide nitride (HfON), hafnium silicon oxide (HfSiON), lanthanum oxide (LaO), lanthanum aluminum oxide (LaAlO), zirconium oxide (ZrO), zirconium silicate (ZrSiO), zirconium oxide nitride (ZrON), Zirconium silicon oxide nitride (ZrSiON), tantalum oxide (TaO), titanium oxide (TiO), barium strontium titanium oxide (BaSrTiO), barium titanium oxide (BaTiO), titanium zirconate lead (PZT), strontium bismuth tantalate (STB), bismuth iron oxide (BFO), strontium titanium oxide (SrTiO), yttrium oxide (YO), aluminum oxide (AlO), or lead scandium tantalum oxide (PbScTaO).

In some embodiments, the plurality of bit lines BL may extend in the vertical direction Z and may be spaced apart from each other in the second horizontal direction Y on the first substrate 110. The plurality of bit lines BL may be any one of a doped semiconductor material, conductive metal nitride, a metal, and a metal-semiconductor compound.

In some embodiments, the cell capacitor CAP may include a first electrode EL1, a capacitor dielectric layer DL, and a second electrode EL2. The first electrode EL1 may extend in the first horizontal direction X and may be spaced apart from each other in the vertical direction Z. The first electrode EL1 may have an inner space (not shown) extending in the first horizontal direction X, and the inner space may be filled by the capacitor dielectric layer DL and the second electrode EL2. For example, the first electrode EL1 may have a cup shape rotated at 90 degrees.

In some embodiments, the capacitor dielectric layer DL may include at least one of a high-k dielectric material having a higher dielectric constant than silicon oxide or a ferroelectric material. In some embodiments, the capacitor dielectric layer DL may include at least one material selected from hafnium oxide (HfO), hafnium silicate (HfSiO), hafnium oxide nitride (HfON), hafnium silicon oxide (HfSiON), lanthanum oxide (LaO), lanthanum aluminum oxide (LaAlO), zirconium oxide (ZrO), zirconium silicate (ZrSiO), zirconium oxide nitride (ZrON), Zzirconium silicon oxide nitride (ZrSiON), tantalum oxide (TaO), titanium oxide (TiO), barium strontium titanium oxide (BaSrTiO), barium titanium oxide (BaTiO), titanium zirconate lead (PZT), strontium bismuth tantalate (STB), bismuth iron oxide (BFO), strontium titanium oxide (SrTiO), yttrium oxide (YO), aluminum oxide (AlO), or lead scandium tantalum oxide (PbScTaO).

In some embodiments, the second electrode EL2 may fill the inner space of the first electrode EL1, and the capacitor dielectric layer DL may be disposed between the inner space of the first electrode EL 1 and the second electrode EL2.

In some embodiments, the first electrode EL1 and the second electrode EL2 may each include a doped semiconductor material, a conductive metal nitride such as titanium nitride, tantalum nitride, niobium nitride, or tungsten nitride, a metal of ruthenium, iridium, titanium or tantalum, or a conductive metal oxide such as iridium oxide or niobium oxide.

In some embodiments, the plate electrode PP may be disposed to extend in the vertical direction Z and the second horizontal direction Y on one side of the cell capacitor CAP. The second electrode EL2 of the cell capacitor CAP may be electrically connected to the plate electrode PP. For example, the plurality of second electrodes EL2 disposed to be spaced apart from each other in the vertical direction Z and the plurality of second electrodes EL2 disposed to be spaced apart from each other in the second horizontal direction Y may be commonly connected to the plate electrode PP.

In some embodiments, a mold insulating layer 122 may be disposed between two adjacent semiconductor patterns 120, which are disposed to be spaced apart in the vertical direction Z, and the mold insulating layer 122 may be disposed between two adjacent word lines WL, which are disposed to be spaced apart in the vertical direction Z, and the mold insulating layer 122 may be disposed between two adjacent first electrodes EL1, which are disposed to be spaced apart in the vertical direction Z. In addition, the mold insulating layer 122 may be disposed between two bit lines BL, which are disposed to be spaced apart in the second horizontal direction Y.

In some embodiments, the mold insulating layer 122 may include silicon oxide, silicon oxynitride, silicon nitride, carbon-containing silicon oxide, carbon-containing silicon oxynitride, carbon-containing silicon nitride, or a combination thereof. In some embodiments, the mold insulating layer 122 may include a plurality of insulating layers. Here, the mold insulating layer 122 may collectively refer to insulating material layers that are formed between the plurality of bit lines BL, the plurality of word lines WL, the plurality of semiconductor patterns 120, and the plurality of cell capacitors CAP according to a manufacturing process employed to form a 3D structure of the memory device 10.

In some embodiments, the first stack structure SS1 may include an upper wiring structure 150. The upper wiring structure 150 may include a wiring layer 152, a via 154, and an insulating layer 156. The upper wiring structure 150 may further include a contact 158 electrically connected to the bit line BL, the word line WL, and the plate electrode PP. In addition, the first bonding pad BP1 disposed on the same plane as an uppermost surface of the insulating layer 156 may be formed on the upper wiring structure 150.

In some embodiments, the second stack structure SS2 may include a second substrate 310, a peripheral circuit transistor 320 disposed on the second substrate 310, a front wiring structure 330 covering the peripheral circuit transistor 320 on an upper surface of the second substrate 310, and a rear wiring structure 340 disposed on a bottom surface of the second substrate 310. The front wiring structure 330 may include a wiring layer 332, a via 334, and an insulating layer 336, and the rear wiring structure 340 may include a wiring layer 342, a via 344, and an insulating layer 346.

In some embodiments, the rear wiring structure 340 may include the second bonding pad BP2 disposed on the same plane as a bottom surface of the insulating layer 346, and the first stack structure SS1 and the second stack structure SS2 may be bonded to each other when the second bonding pad BP2 and the first bonding pad BP1 are connected to each other. In some embodiments, the first stack structure SS1 and the second stack structure SS2 may be attached by a copper-oxide hybrid bonding method. In some embodiments, the second bonding pad BP1 and the first bonding pad BP2 may include copper or a copper alloy. An interface between the insulating layer 156 of the upper wiring structure 150 and the insulating layer 346 of the rear wiring structure 340 may extend flat, and may be disposed on the same plane as an interface between the second bonding pad BP2 and the first bonding pad BP1.

In some embodiments, the peripheral circuit transistor 320 may include a gate electrode 322 and a gate insulating layer 324 disposed on an active region of the second substrate 310.

In some embodiments, the second stack structure SS2 may further include a through via 350 penetrating the second substrate 310. The wiring layer 332 included in the front wiring structure 330 may be electrically connected to the wiring layer 342 included in the rear wiring structure 340 by the through via 350. In addition, the wiring layer 342 included in the rear wiring structure 340 may be electrically connected to the wiring layer 152 included in the upper wiring structure 150 through the second bonding pad BP2 and the first bonding pad BP1.

In some embodiments, the peripheral circuit transistor 320 disposed in the first core region CR1 may be included in a first row decoder (e.g., 112 in FIG. 1), and the peripheral circuit transistor 320 disposed in the second core region CR2 may be included in a second row decoder (e.g., 113 in FIG. 1). The first row decoder may be physically connected to a word line pad WLP located at first end portions of the word lines WL1 to WL3 included in the first word line group WLg1 through the upper wiring structure 150, the rear wiring structure 340, and the front wiring structure 330 (which may be collectively referred to as a first contact plug). The second row decoder may be physically connected to the word line pad WLP located at second end portions of the word lines WL4 to WL6 included in the second word line group WLg2 through the upper wiring structure 150, the rear wiring structure 340, and the front wiring structure 330 (which may be collectively referred to as a second contact plug). On the other hand, the first row decoder may be physically disconnected from a word line pad WLP provided at second end portions of the word lines WL1 to WL3 included in the first word line group WLg1 and physically disconnected from a word line pad WLP provided at first end portions of the word lines WL4 to WL6 included in the second word line group WLg2.

The word line pads WLP located at the first end portions of the word lines WL1 to WL3 included in the first word line group WLg1 may be arranged in a step structure. Second end portions of the word lines WL1 to WL3 included in the first word line group WLg1 may be arranged in a cliff structure. The second end portions of the word lines WL1 to WL3 included in the first word line group WLg1 may be arranged in the cliff structure rather than the step structure, and thus, a length of the first stack structure SS1 in a Y-axis direction may be reduced.

The word line pads WLP located at the second end portions of the word lines WL4 to WL6 included in the second word line group WLg2 may be arranged in the step structure. First end portions of the word lines WL4 to WL6 included in the second word line group WLg2 may be arranged in the cliff structure. The first end portions of the word lines WL4 to WL6 included in the second word line group WLg2 may be arranged in the cliff structure rather than the step structure, and thus, the length of the first stack structure SS1 in the Y-axis direction may be reduced.

In FIG. 11, the first word line group WLg1 may include three word lines WL1 to WL3 and the second word line group WLg2 may include three word lines WL4 to WL6, but the embodiments are not limited thereto. For example, entire word lines may include 100 word lines, and accordingly, 50 word lines WL1 to WL50 may be included in the first word line group WLg1, and 50 word lines WL51 to WL100 may be included in the second word line group WLg2.

Dummy word lines may be added between adjacent word line groups. That is, a dummy word line may be added between the first word line group WLg1 and the second word line group WLg2. The dummy word lines may be disposed between adjacent word lines driven in opposite directions among the word lines WL1 to WL3 of the first word line group WLg1 and the word lines WL4 to WL6 of the second word line group WLg2, and thus, signal interference between the word lines WL1 to WL6 may be reduced.

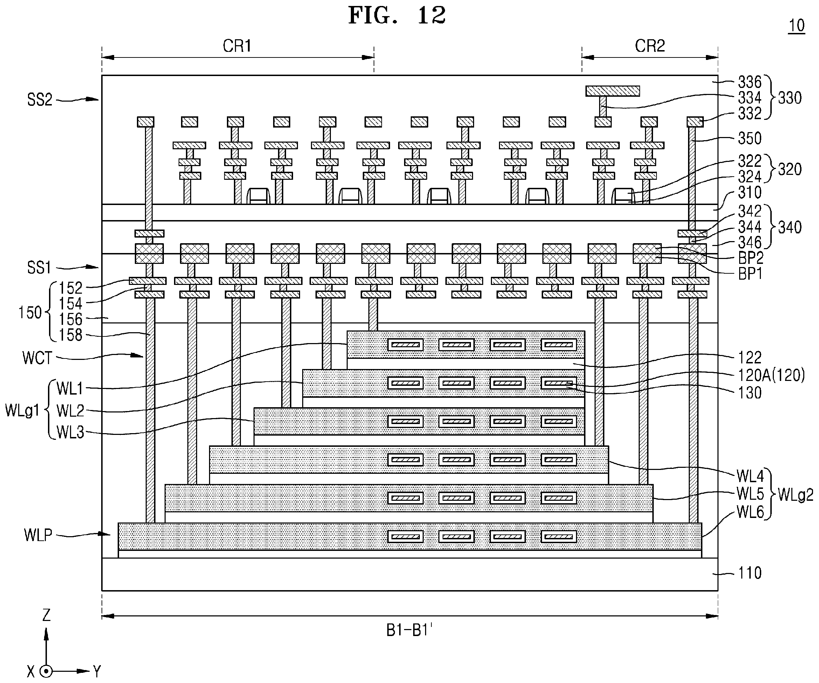

FIG. 12 is a cross-sectional view of a memory device including the memory cell region taken along line B1-B1' of FIG. 9.

Referring to FIG. 12, unlike FIG. 11, first end portions of the word lines WL4 to WL6 included in the second word line group WLg2 may be arranged in a step structure. That is, the word line pads WLP located at the first end portions of the word lines WL4 to WL6 may be arranged in the step structure.

A row decoder (e.g., 112 in FIG. 1) located in the first core region CR1 may be physically connected to the first end portions of the word lines WL4 to WL6 included in the second word line group WLg2. That is, in FIG. 12, the word lines WL4 to WL6 included in the second word line group WLg2 may receive driving voltage from the first row decoder 112 and the second row decoder 113 through the first end portions and the second end portions, respectively, and may be driven in both directions.

A length of a word line pad formed in at least one of both end portions of a word line may increase as the word line is located at a lower portion, and thus, a resistor-capacitor (RC) delay due to the word line located at the lower portion may increase. According to one or more embodiments, the second word line group WLg2 located at the lower portion may be driven in both directions, and thus, driving performance may be improved. However, the embodiment is not limited thereto. For example, some word lines located at an upper portion among the word lines WL1 to WL6 may be driven in one direction, and remaining word lines may be driven in both directions, and thus, driving performance may be improved.

In FIG. 12, the first word line group WLg1 may include three word lines WL1 to WL3, and the second word line group WLg2 may include three word lines WL4 to WL6, but the embodiments are not limited thereto. For example, entire word lines may include 100 word lines, and accordingly, 50 word lines WL1 to WL50 may be included in the first word line group WLg1, and 50 word lines WL51 to WL100 may be included in the second word line group WLg2.

Dummy word lines may be added between adjacent word line groups. That is, a dummy word line may be added between the first word line group WLg1 and the second word line group WLg2. The dummy word lines may be disposed between adjacent word lines driven in opposite directions among the word lines WL1 to WL3 of the first word line group WLg1 and the word lines WL4 to WL6 of the second word line group WLg2, and thus, signal interference between the word lines WL1 to WL6 may be reduced.

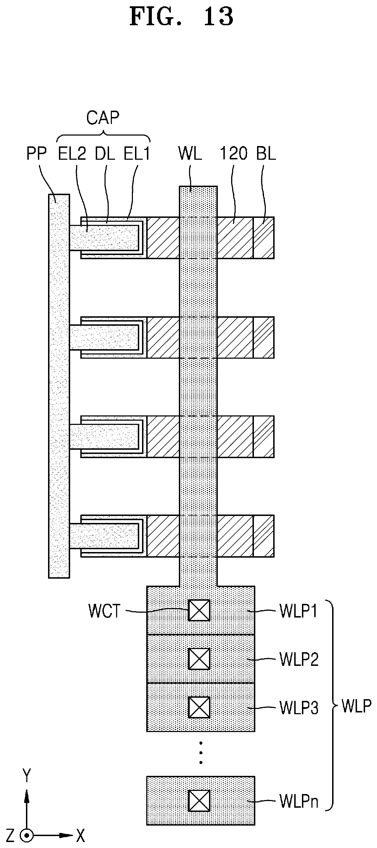

FIG. 13 is a layout view schematically illustrating the memory device 10 according to one or more embodiments.

Referring to FIG. 13 together with FIGS. 11 and 12, the word line WL may extend in the second horizontal direction (Y direction) to cross the first horizontal direction (X direction), which is a direction in which the first semiconductor pattern 120 extends. The word line pad WLP may be disposed at an end portion of the word line WL. As shown in FIG. 13, a plurality of word line pads WLP may be arranged sequentially in the second horizontal direction (Y direction), and as shown in FIG. 12, the plurality of word line pads WLP may be arranged in a step shape in the second horizontal direction (Y direction).

In some embodiments, n word line pads WLP1 to WLPn connected to first to nth word lines WL may be disposed in the second horizontal direction (Y direction), such as a first word line pad WLP1 connected to an uppermost word line WL, a second word line pad WLP2 connected to the word line WL disposed below the uppermost word line WL, and a third word line pad WLP3 connected to the word line WL disposed below the two uppermost word lines WL being disposed sequentially in the second horizontal direction Y, etc.

A word line contact WCT may be disposed on an upper surface of each of the word line pads WLP, and the word line WL may be electrically connected to the upper wiring structure 150 by the word line contact WCT.

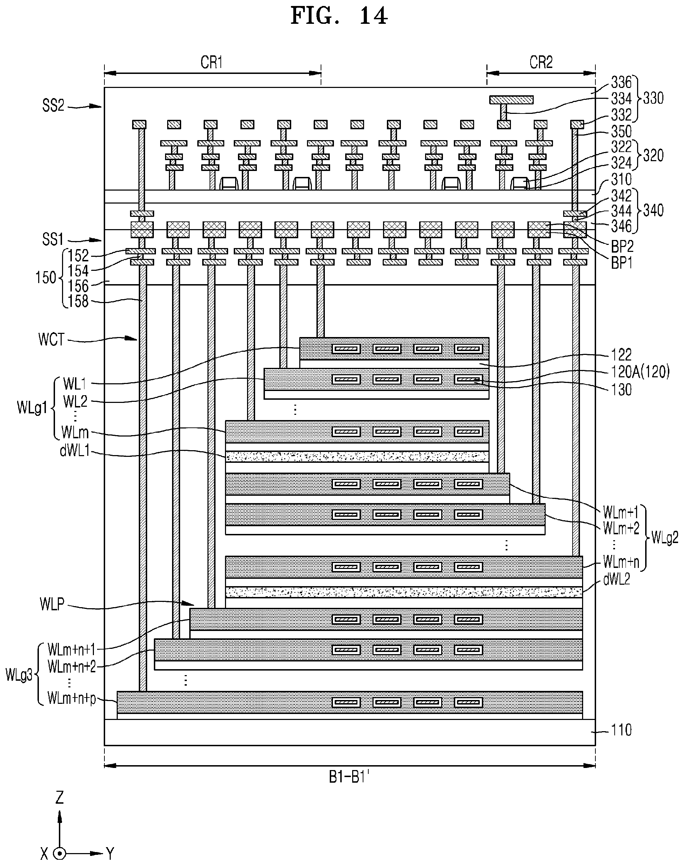

FIG. 14 is a cross-sectional view of a memory device including the memory cell region taken along line B1-B1' of FIG. 9.

Referring to FIG. 14, the first stack structure SS1 may include word lines WL1 to WLm+n+p. m, n, and p may each be a natural number greater than or equal to 2. The word lines WL1 to WLm may be referred to as the first word line group WLg1, the word lines WLm+1 to WLm+n may be referred to as the second word line group WLg2, and the word lines WLm+n+1 to WLm+n+p may be referred to as a third word line group WLg3.

The first word line group WLg1 and the third word line group WLg3 may receive driving voltages through first end portions of word lines included therein. The first word line group WLg1 and the third word line group WLg3 may be physically connected to a row decoder disposed in the first core region CR1.

The second word line group WLg2 may receive driving voltages through second end portions of word lines included therein. The second word line group WLg2 may be physically connected to a row decoder disposed in the second core region CR2.

A first dummy word line dWL1 may be disposed between the first word line group WLg1 and the second word line group WLg2, and a second dummy word line dWL2 may be disposed between the second word line group WLg2 and the third word line group WLg3. The first dummy word line dWL1 and the second dummy word line dWL2 may be electrically disconnected from the row decoder disposed in the first core region CR1 or the second core region CR2.

The word line WLm and the word line WLm+1 may be driven in opposite directions, and thus, signal interference between the word line WLm and the word line WLm+1 may be increased. Therefore, the first dummy word line dWL1 may be disposed between the word line WLm and the word line WLm+1 driven in opposite directions, and thus, signal interference between the word line WLm and the word line WLm+1 may be reduced. Likewise, the second dummy word line dWL2 may be disposed between the word line WLm+n and the word line WLm+n+1, and thus, signal interference between the word line WLm+n and the word line WLm+n+1 may be reduced.

In addition, the first word line group WLg1, the second word line group WLg2, and the third word line group WLg3 are shown in FIG. 14, but a number of word line groups is not limited thereto. Adjacent word line groups may be driven in opposite directions. For example, entire word lines may be 100 word lines, and may be configured in the first word line group WLg1, the second word line group WLg2, the third word line group WLg3, and a fourth word line group WLg4. Accordingly, 25 word lines may be included in the first word line group WLg1, 25 word lines may be included in the second word line group WLg2, 25 word lines may be included in the third word line group WLg3, and 25 word lines may be included in the fourth word line group WLg4.

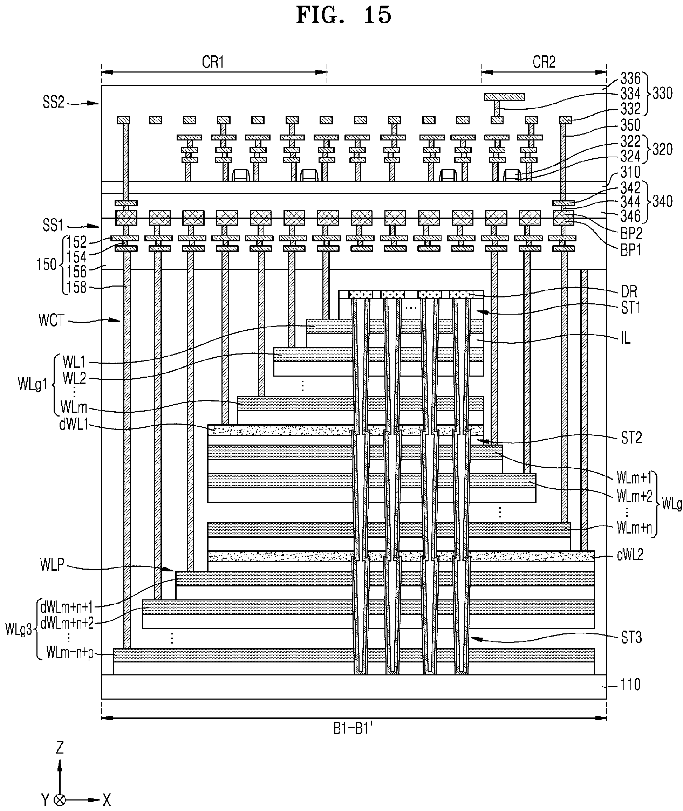

FIG. 15 is a cross-sectional view of a memory device including the memory cell region taken along line B1-B1' of FIG. 9.

Referring to FIG. 15, a plurality of insulating layers IL extending in the first horizontal direction X may be sequentially provided on the first substrate 110 in the vertical direction Z, and the plurality of insulating layers IL may be spaced apart from each other by a specific distance in the vertical direction Z. For example, the plurality of insulating layers IL may each include an insulating material such as silicon oxide.

First to third stacks ST1 to ST3 penetrating the plurality of insulating layers IL in the vertical direction Z may be provided. The first to third stacks ST1 to ST3 may form a channel structure. The first to third stacks ST1 to ST3 may be formed through different processes. A number of stacks included in the channel structure is not limited thereto. Each of the first to third stacks ST1 to ST3 may include a data storage layer, a channel layer, a buried insulating layer, etc. As a length of the channel increases, it may become difficult to form the channel having a constant width due to process reasons. A channel having an improved width uniformity may be provided through the first to third stacks ST1 to ST3 formed by sequential processes.

The channel structure formed by the first to third stacks ST1 to ST3 may penetrate the plurality of insulating layers IL to be in contact with a substrate 110.

Drains or drain contacts DR may be provided on the channel structure. For example, the drains or the drain contacts DR may include a silicon material doped with impurities having a second conductivity type. Bit lines extending in the second horizontal direction Y and spaced apart from each other by a specific distance in the first horizontal direction X may be provided on the drains DR.

The first dummy word line dWL1 may be disposed near a boundary between the first and second stacks ST1 and ST2. The second dummy word line dWL2 may be disposed near a boundary between the second and third stacks ST2 and ST3. A word line pad of the first dummy word line dWL1 may be connected to a first row decoder through the upper wiring structure 150, the rear wiring structure 340, and the front wiring structure 330. A word line pad of the second dummy word line dWL2 may be connected to a second row decoder through the upper wiring structure 150, the rear wiring structure 340, and the front wiring structure 330.

Data may not be stored in memory cells connected to the first dummy word line dWL1 and the second dummy word line dWL2. Alternatively, a number of pages corresponding to the memory cells connected to the first dummy word line dWL1 and the second dummy word line dWL2 may be less than a number of pages corresponding to memory cells connected to a general word line. Voltage levels applied to the first dummy word line dWL1 and the second dummy word line dWL2 may be different from a voltage level applied to the general word line, and accordingly, an influence of a non-uniform channel width on an operation of a memory device may be reduced.

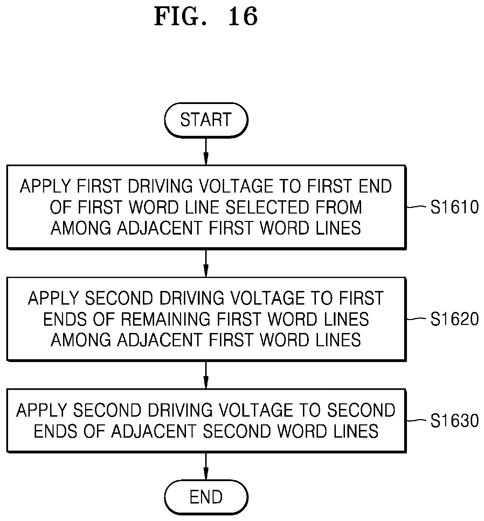

FIG. 16 is a flowchart illustrating an operating method of a memory device according to one or more embodiments.

The operating method of the memory device described with reference to FIG. 16 may be one of a write operation, a read operation, an erase operation, and a refresh operation. By the operating method of the memory device of FIG. 16, an internal operation of the memory device may be performed on a word line selected from among a plurality of word lines.

Referring to FIG. 16, the memory device may apply a first driving voltage to a first end portion of both end portions of a first word line selected from among adjacent first word lines (S1610). The adjacent first word lines may be, for example, the word lines WL1 to WLm or the word lines WLm+1 to WLm+n of FIG. 1. When the adjacent first word lines are the word lines WL1 to WLm of FIG. 1, the first row decoder 112 may apply the first driving voltage to a first end portion of a word line (e.g., WLm) selected from among the word lines WL1 to WLm. When the adjacent first word lines are the word lines WLm+1 to WLm+n of FIG. 1, the second row decoder 113 may apply the first driving voltage to a second end portion of a word line (e.g., WLm+2) selected from among the word lines WLm+1 to WLm+n.

In some embodiments, the memory device may apply the first driving voltage to a second end portion of the first word line selected from among the adjacent first word lines. That is, the memory device may apply the first driving voltage to both end portions of the first word line selected from among the adjacent first word lines. For example, when selected first word lines correspond to the word lines WL4 to WL6 of FIG. 12, the memory device may apply the first driving voltage to both first and second end portions of the first word lines corresponds to the word lines WL4 to WL6. The word lines WL4 to WL6 may be longer than the word lines WL1 to WL3 as shown in FIG. 12, and thus, driving performance may be improved by applying a driving voltage to the first word lines corresponding to the word lines WL4 to WL6 in both directions.

The memory device may apply the second driving voltage to first end portions of remaining first word lines among the adjacent first word lines (S1620). When the adjacent first word lines are the word lines WL1 to WLm of FIG. 1, the first row decoder 112 may apply the second driving voltage to first end portions of remaining word lines WL1 to WLm-1 among the word lines WL1 to WLm. When the adjacent first word lines are the word lines WLm+1 to WLm+n of FIG. 1, the second row decoder 113 may apply the second driving voltage to second end portions of remaining word lines WLm+1 and WLm+3 to WLm+n among the word lines WLm+1 to WLm+n. In some embodiments, the second driving voltage may be greater than the first driving voltage. In some embodiments, the second driving voltage may be less than the first driving voltage.

The memory device may apply the second driving voltage to second end portions of adjacent second word lines (S1630). The adjacent second word lines may be different from the adjacent first word lines. For example, when the adjacent first word lines are the word lines WL1 to WLm of FIG. 1, the adjacent second word lines may be the word lines WLm+1 to WLm+n of FIG. 1. For example, when the adjacent first word lines are the word lines WLm+1 to WLm+n of FIG. 1, the adjacent second word lines may be the word lines WL1 to WLm of FIG. 1. When the adjacent second word lines are the word lines WLm+1 to WLm+n of FIG. 1, the second row decoder 113 may apply the second driving voltage to second end portions of the word lines WLm+1 to WLm+n. When the adjacent second word lines are the word lines WL1 to WLm of FIG. 1, the first row decoder 112 may apply the second driving voltage to second end portions of the word lines WL1 to WLm.

In some embodiments, the memory device may also apply the second driving voltage to first end portions of the adjacent second word lines. For example, when the adjacent second word lines correspond to the word lines WL4 to WL6 of FIG. 12, the memory device may apply the second driving voltage to both first and second end portions of second word lines corresponding to the word lines WL4 to WL6. The word lines WL4 to WL6 may be longer than the word lines WL1 to WL3 as shown in FIG. 12, and thus, driving performance may be improved by applying the driving voltage to the adjacent second word lines corresponding to the word lines WL4 to WL6 in both directions.

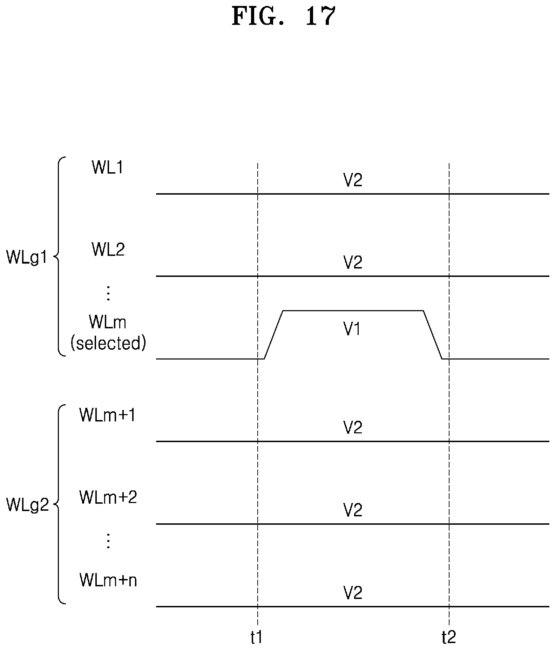

FIG. 17 is a diagram illustrating a first driving voltage V1 and a second driving voltage V2 applied to the word lines WL1 to WLm and WLm+1 to WLm+n according to one or more embodiments.

Referring to FIGS. 1 and 17, the first row decoder 112 may select the word line WLm corresponding to the address ADDR.

In a time period between a first time t1 and a second time t2, the first row decoder 112 may provide a driving voltage to first end portions of the word lines WL1 to WLm. Specifically, the first row decoder 112 may provide the second driving voltage V2 to the first end portions of the word lines WL1 to WLm-1, and may provide the first driving voltage V1 to the first end portion of the word line WLm. The first driving voltage V1 may be greater than the second driving voltage V2. In another embodiment, unlike FIG. 17, in the time period between the first time t1 and the second time t2, the first row decoder 112 may provide a third driving voltage V3 to the first end portions of the word lines WL1 to WLm-1. The third driving voltage V3 may be greater than the second driving voltage V2 and less than the first driving voltage V1. In some embodiments, the third driving voltage V3 may be greater than the first driving voltage V1.

In the time period between the first time t1 and the second time t2, the second row decoder 113 may provide the second driving voltage V2 to second end portions of the word lines WLm+1 to WLm+n. In some embodiments, the first row decoder 112 may provide the second driving voltage V2 to first end portions of the word lines WLm+1 to WLm+n. That is, when lengths of the word lines WLm+1 to WLm+n are longer than lengths of the word lines WL1 to WLm, the first and second row decoders 112 and 113 may provide improved driving performance by driving the word lines WLm+1 to WLm+n in both directions.

In another embodiment, unlike FIG. 17, in the time period between the first time t1 and the second time t2, the second row decoder 113 may provide the third driving voltage V3 to the second end portions of the word lines WLm+1 to WLm+n, and the third driving voltage V3 may be greater than the second driving voltage V2 and less than the first driving voltage V1. In some embodiments, the third driving voltage V3 may be greater than the first driving voltage V1.

For example, when the memory device 10 is a flash memory device, the third driving voltage V3 greater than the first driving voltage V1 may be provided to the word lines WL1 to WLm-1 and WLm+1 to WLm+n in the time period between the first time t1 and the second time t2 during a read operation. The third driving voltage V3 may be referred to as a pass voltage, and the first driving voltage V1 may be referred to as a read voltage. When the memory device 10 is a flash memory device, the third driving voltage V3 greater than the second driving voltage V2 and less than the first driving voltage V1 may be provided to the word lines WL1 to WLm-1 and WLm+1 to WLm+n in the time period between the first time t1 and the second time t2 during a write operation. The third driving voltage V3 may be referred to as a pass voltage, and the first driving voltage V1 may be referred to as a program voltage.

In some embodiments, as described above with reference to FIG. 15, a dummy word line may be disposed between the first word line group WLg1 and the second word line group WLg2. When the memory device 10 is a flash memory device, a voltage that is the same as a voltage applied to unselected word lines WL1 to WLm-1, WLm+1, and WLm+n, a voltage greater than the voltage applied to the unselected word lines WL1 to WLm-1, WLm+1, and WLm+n, or a voltage less than the voltage applied to the unselected word lines WL1 to WLm-1, WLm+1, and WLm+n may be applied to the dummy word line in the time period between the first time t1 and the second time t2.

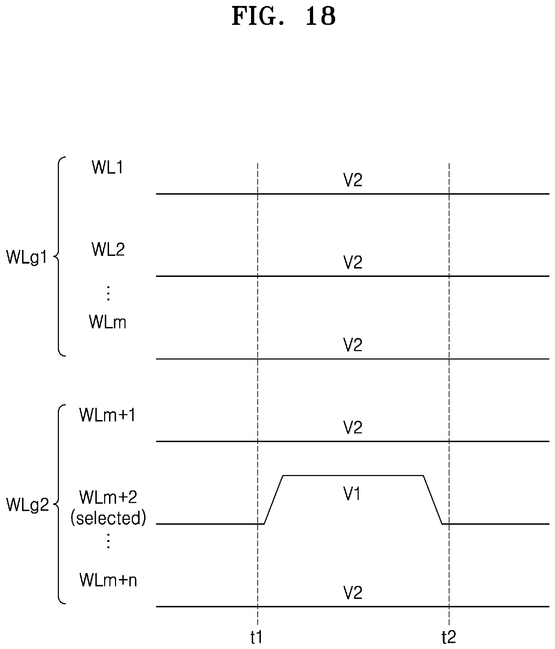

FIG. 18 is a diagram illustrating the first driving voltage V1 and the second driving voltage V2 applied to the word lines WL1 to WLm and WLm+1 to WLm+n according to one or more embodiments. Overlapping descriptions given above with reference to FIG. 17 may be omitted.

Referring to FIGS. 1 and 18, the second row decoder 113 may select a word line WLm+2 corresponding to the address ADDR.

In a time period between the first time t1 and the second time t2, the second row decoder 113 may provide a driving voltage to second end portions of the word lines WLm+1 to WLm+n. Specifically, the second row decoder 113 may provide the second driving voltage V2 to the second end portions of the word lines WLm+1 and WLm+3 to WLm+n, and may provide the first driving voltage V1 to the second end portion of the word line WLm+2. The first driving voltage V1 may be greater than the second driving voltage V2. In some embodiments, the first row decoder 112 may provide the driving voltage to first end portions of the word lines WLm+1 to WLm+n. For example, the first row decoder 112 may provide the second driving voltage V2 to the first end portions of the word lines WLm+1 and WLm+3 to WLm+n, and may provide the first driving voltage V1 to the first end portion of the word line WLm+2. That is, when lengths of the word lines WLm+1 to WLm+n are longer than lengths of the word lines WL1 to WLm, the first and second row decoders 112 and 113 may provide improved driving performance by driving the word lines WLm+1 to WLm+n in both directions.

In another embodiment, unlike FIG. 18, the second row decoder 113 may provide the third driving voltage V3 to second end portions of the word lines WLm+1 and WLm+3 to WLm+n in the time period between the first time t1 and the second time t2. The third driving voltage V3 may be greater than the second driving voltage V2 and less than the first driving voltage V1. In some embodiments, the third driving voltage V3 may be greater than the first driving voltage V1.

In the time period between the first time t1 and the second time t2, the first row decoder 112 may provide the second driving voltage V2 to the first end portions of the word lines WL1 to WLm.

In another embodiment, unlike FIG. 18, the first row decoder 112 may provide the third driving voltage V3 to the first end portions of the word lines WL1 to WLm in the time period between the first time t1 and the second time t2. The third driving voltage V3 may be greater than the second driving voltage V2 and less than the first driving voltage V1. In some embodiments, the third driving voltage V3 may be greater than the first driving voltage V1.

In the above embodiments, the control logic circuits 111, 2010 and 3150 may each be implemented by at least one processor such as a central processing unit (CPU), a graphic processing unit (GPU) and/or another type of microprocessor, and an internal memory to perform the above-described functions by executing computer code or instructions stored in the internal or external memory. Further, the row decoders 112, 113, 2060, 3121, and 3122 may be implemented by dedicated hardware including one or more of logic gates or circuits, registers, memories, interface circuits, etc. configured to perform the above-described functions in association with the control logic circuits 111, 2010 and 3150, respectively.

While the disclosure has been particularly shown and described with reference to example embodiments thereof, it will be understood that various changes in form and details may be made therein without departing from the scope of the following claims.

## Claims

1. A memory device comprising:
a set of word lines stacked in a vertical direction on a semiconductor substrate and each word line of the set of words lines extending from a first end portion to a second end portion in a first direction perpendicular to the vertical direction, the set of word lines comprising a first subset of word lines, a second subset of word lines, and a set of word line pads including a first subset of pads and a second subset of pads; and
a row decoder configured to provide a driving voltage to the set of word lines,
wherein the first subset of word lines are sequentially stacked, and the first subset of pads disposed at the first end portions of the first subset of word lines, are connected to the row decoder, and
wherein the second subset of word lines are sequentially stacked, and the second subset of pads disposed at the second end portions of the second subset of word lines are connected to the row decoder.

2. The memory device of claim 1, wherein the first end portions of the first subset of word lines have a step structure, and the second end portions of the first subset of word lines have a cliff structure.

3. The memory device of claim 1 or claim 2, wherein the second end portions of the second subset of word lines have a step structure, and the first end portions of the second subset of word lines have a cliff structure.

4. The memory device of claim 2, wherein the second end portions of the second subset of word lines have a step structure, and the first end portions of the second subset of word lines have a step structure.

5. The memory device of any preceding claim, wherein the set of word lines include a dummy word line located between a first word line among the first subset of word lines and a second word line among the second subset of word lines, the dummy word line being electrically disconnected from the row decoder.

6. The memory device of any preceding claim, wherein third word line pads provided at the second end portions of the first subset of word lines are physically disconnected from the row decoder.

7. The memory device of claim 6, wherein fourth word line pads provided at the first end portions of the second subset of word lines are physically disconnected from the row decoder.

8. The memory device of claim 6, wherein fourth word line pads provided at the first end portions of the second subset of word lines are connected to the row decoder.

9. The memory device of claim 8, wherein the first subset of word lines is stacked on the second subset of word lines, and
wherein a length of the first subset of wordlines in the first direction is shorter than a length of any word line among the second subset of word lines in the first direction.

10. The memory device of any preceding claim, wherein the set of word lines are disposed in a first semiconductor region,
wherein the row decoder is disposed in a second semiconductor region,
wherein the first word line pads are connected to the row decoder through first contact plugs, the first contact plugs extending in the vertical direction, and
wherein the second word line pads are connected to the row decoder through second contact plugs, the second contact plugs extending in the vertical direction.

11. An operating method of a memory device, the memory device comprising a plurality of memory cells connected to a set of word lines stacked in a vertical direction including a first subset of word lines and a second subset of word lines, the set of word lines extending from a first end portion to a second end portion in a first direction perpendicular to the vertical direction, the operating method comprising:
applying a first driving voltage to the first end portion of a first word line among the first subset of word lines adjacent in the vertical direction;
applying a second driving voltage to the first end portions of the first subset of word lines excluding the first word line; and
applying the second driving voltage to the second end portions of a second subset of word lines adjacent in the vertical direction.

12. The operating method of claim 11, further comprising:
applying the second driving voltage to a third word line located between the first subset of word lines and the second subset of word lines.

13. The operating method of claim 11 or claim 12, further comprising:
applying the second driving voltage to the first end portions of the second subset of word lines,
wherein a length of the first subset of wordlines in the first direction is shorter than a length of any word line among the second subset of word lines in the first direction.

14. The operating method of any of claims 11-13, further comprising:
applying the first driving voltage to the second end portion of the first word line; and
applying the second driving voltage to the second end portions of the first subset of word lines excluding the first word line,
wherein a length of a shortest first word line among the first subset of word lines is longer than a length of a longest second word line among the second subset of word lines.

15. The operating method of any of claims 11-14, wherein the first driving voltage is greater than the second driving voltage.
